# EUROPEAN PATENT APPLICATION

(11) **EP 4 579 250 A1**
(43) Date of publication of application: **02.07.2025**
(21) Application number: 24849358.7
(22) Date of filing: 17.06.2024
(51) Int. Cl.: G01R 22/06, H02J 13/00, H02J 3/32, G08C 19/00

(54) **POWER SYSTEM AND COMMUNICATION METHOD THEREOF**

(30) Priority: 03.08.2023 KR 20230101504
(71) Applicant: LG Energy Solution, Ltd., Seoul 07335 (KR)
(72) Inventor: YANG, Seongyeol, Daejeon 34122 (KR); KIM, Dukyou, Daejeon 34122 (KR); LEE, Yeseul, Daejeon 34122 (KR)
(74) Representative: BCKIP Part mbB
(86) International application number: PCT/KR2024/008279
(87) International publication number: WO 2025/028787

(57) **Abstract**

Disclosed is an apparatus according to embodiments of the present invention, which includes a first power conversion device; a second power conversion device; a first communication line connecting the first power conversion device and the second power conversion device; and a second communication line connecting the first power conversion device and the second power conversion device.

Here, each of the first power conversion device and the second power conversion device measures one or more state values for a monitoring object and exchanges the measured state values through the first communication line, and one or more of the first power conversion device and the second power conversion device performs communication to synchronize measurement time points of the state values through the second communication line.

## Description

### [Technical Field]

This application claims priority to and the benefit of Korean Patent Application No.10-2023-0101504 filed in the Korean Intellectual Property Office on August 3, 2023 the entire contents of which are incorporated herein by reference.

The present invention relates to a power system and a communication method thereof, and more particularly, to a power system and a communication method thereof that can minimize measurement errors between power conversion devices.

### [Background Art]

An energy storage system (ESS) relates to renewable energy, a battery that stores electric power, and a power grid. Recently, as a spread of smart grid and renewable energy is expanding and efficiency and stability of the power system are emphasized, a demand for energy storage systems for power supply and demand control and power quality improvement is increasing. Depending on a purpose of use, energy storage systems may have different outputs and capacities. In order to configure a large-capacity energy storage system, a plurality of battery systems may be connected.

An energy storage system connected with a PV (Photovoltaic) system is changing from an AC-coupled system to a DC-coupled system. In a DC-coupled energy storage system, the PV system and the battery system operate in DC voltages, but the power grid operates in AC voltages, and thus, a power conversion/conditioning system (PCS) including a DC/AC inverter is installed in each battery section and a DC/DC converter is provided in the battery system. Here, the power conversion system controls the power supplied from the grid and the power supplied externally from the battery section, and the output of the DC/DC converter is connected to the PCS to control the DC voltage/current of the battery system.

When the inverter and the converter are operated in conjunction, the inverter and the converter independently measure state values of a monitoring target (for example, voltage values and current values of the DC link) and use the measured state values for control and diagnosis. Here, if the measurement timings of the state values measured by the inverter and the converter are different from each other, diagnostic accuracy may be reduced or a loss in power conversion gain may occur.

Accordingly, appropriate communication technology is needed to match measurement timing between power conversion devices, improve diagnostic accuracy, and minimize loss of power conversion gain.

### [Detailed Description of the Invention]

### [Technical Problem]

To obviate one or more problems of the related art, embodiments of the present disclosure provide a power system that can minimize measurement errors between power conversion devices.

To obviate one or more problems of the related art, embodiments of the present disclosure also provide a communication method for the power system.

### [Technical Solution]

In order to achieve the objective of the present disclosure, a power system according to embodiments of the present invention may include a first power conversion device; a second power conversion device; a first communication line connecting the first power conversion device and the second power conversion device; and a second communication line connecting the first power conversion device and the second power conversion device. Here, each of the first power conversion device and the second power conversion device measures one or more of state values for a monitoring object and exchanges the measured state values through the first communication line, and one or more of the first power conversion device and the second power conversion device performs communication to synchronize measurement time points of the state values through the second communication line.

Here, the second communication line may be a separate line from the first communication line.

Any one of the first power conversion device and the second power conversion device may be configured to transmit a first signal requesting initiation of state value measurement to the other via the second communication line.

One of the first power conversion device and the second power conversion device may be predefined as a transmitting entity of the first signal.

The first power conversion device and the second power conversion device may be configured to transmit the first signal to the other when a predetermined measurement time for itself arrives.

The one transmitting the first signal may measure the one or more state values immediately after transmitting the first signal, the other one receiving the first signal measures the state values immediately after receiving the first signal, and the first power conversion device and the second power conversion device share measured state values with each other through the first communication line.

The measurement periods of the state values of the first power conversion device and the second power conversion device may be predetermined to the same period. Here, any one of the first power conversion device and the second power conversion device may be configured to transmit a second signal indicating arrival of a measurement period of itself to the other via the second communication line.

Among the first power conversion device and the second power conversion device, the one whose measurement period arrives earlier may be configured to transmit the second signal to the other.

The one transmitting the second signal may measure the state values immediately after transmitting the second signal and the other one receiving the second signal may measure the state values, immediately after receiving the second signal. Here, the first power conversion device and the second power conversion device may share measured state values with each other through the first communication line.

The one which transmits the second signal may determine whether the next measurement period has arrived through its own time measuring device immediately after transmitting the second signal. Here, the other one which receives the second signal initializes its own time measuring device immediately after receiving the second signal and determines whether the next measurement period has arrived through its initialized time measuring device.

Upon a specific signal for synchronizing the measurement time points being transmitted and received through the second communication line, each of the first power conversion device and the second power conversion device measures the state values, may update a previously stored counter value and exchange the state values and the counter values through the first communication line.

According to another embodiment of the present disclosure, a communication method relates to a communication method in a power system including a first power conversion device and a second power conversion device interconnected through a first communication line and a second communication line, wherein the method includes transmitting, by any one of the first power conversion device and the second power conversion device, a specific signal for synchronizing measurement time points of state values to the other through the second communication line; measuring, by each of the first power conversion device and the second power conversion device, one or more of state values for a monitoring object; and exchanging, by the first power conversion device and the second power conversion device, the measured state values through the first communication line.

The transmitting the specific signal for synchronizing measurement time points of state value to the other may include transmitting a first signal requesting initiation of measurement of a state value to the other via the second communication line.

The transmitting the specific signal for synchronizing measurement time points of state value to the other may include transmitting, by any one which is predefined as a transmitting entity of the first signal among the first power conversion device and the second power conversion device, the first signal to the other.

The transmitting the specific signal for synchronizing measurement time points of state value to the other may include transmitting, by any one of the first power conversion device and the second power conversion device whose predetermined measurement time point for itself has arrived, the first signal to the other.

The measuring one or more of state values for the monitoring object may include measuring, by any one transmitting the first signal, the state values immediately after transmitting the first signal; and measuring, by the other one receiving the first signal, the state values immediately after receiving the first signal.

Measurement periods of the state value of the first power conversion device and the second power conversion device are predetermined to the same period. Here, the transmitting the specific signal for synchronizing measurement time points of state values to the other may include transmitting a second signal indicating the arrival of the measurement period to the other via the second communication line.

The transmitting the specific signal for synchronizing measurement time points of state value to the other may include transmitting, by any one whose measurement time period arrives earlier among the first power conversion device and the second power conversion device, the second signal to the other one.

The measuring one or more of state values for the monitoring object may include measuring, by the one transmitting the second signal, the state values immediately after transmitting the second signal; and measuring, by the other one receiving the second signal, the state values immediately after receiving the second signal.

The measuring one or more of state values for the monitoring object may include determining, by the one transmitting the second signal, whether the next measurement period has arrived through its own time measuring device immediately after transmitting the second signal; and initializing, by the other one receiving the second signal, its own time measuring device immediately after receiving the second signal and determining whether the next measurement period has arrived through its initialized time measuring device.

The measuring one or more of state values for the monitoring object may further include updating each previously stored counter value. Here, the exchanging the state values may include exchanging the state values and the counter values via the first communication line.

### [Advantageous Effects]

According to the embodiment of the present invention as described above, measurement errors between power conversion devices can be minimized by synchronizing the measurement time points through a communication channel configured separately from a data communication channel and then performing data communication between the power conversion devices.

### [Brief Description of the Drawings]

FIG. 1 is a block diagram showing a communication connection structure of a general power system.
FIG. 2 is a block diagram of a power system according to embodiments of the present invention.
FIG. 3 is an operational flowchart of a communication method of the power system according to the embodiments of present invention.
FIG. 4 is an operational flowchart of a communication method of a power system according to a first embodiment of the present invention.
FIG. 5 is an operational flowchart of a communication method of a power system according to a second embodiment of the present invention.
FIG. 6 is an operational flowchart of a communication method of a power system according to a third embodiment of the present invention.
FIG. 7 is an operational flowchart of a communication method of a power system according to a fourth embodiment of the present invention.

100: first power conversion device
200: second power conversion device
300: monitoring object

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

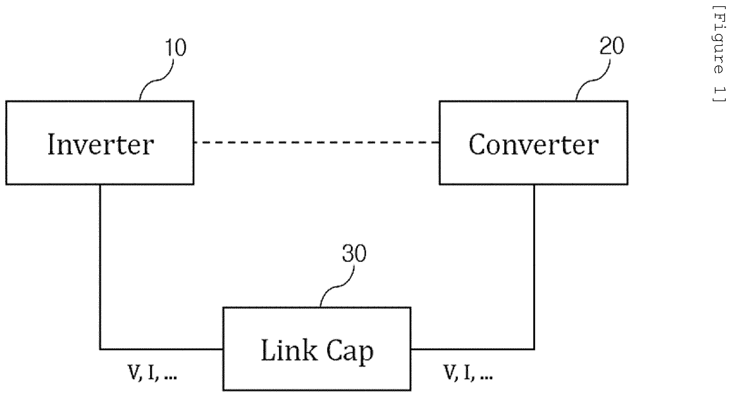

FIG. 1 is a block diagram showing a communication connection structure of a general power system.

Referring to FIG. 1, a general power system may include an inverter 10 and a converter 20. Here, the inverter 10 may be a DC/AC inverter and the converter 20 may be a DC/DC converter.

The inverter 10 and the converter 20 may be connected to a link capacitor 30 through a state measurement line. Here, the inverter 10 and converter 20 may collect state values including voltage values and current values of the link capacitor 30 through the state measurement line.

The inverter 10 and the converter 20 may be connected through a communication line and exchange data with each other. Here, the inverter 10 and the converter 20 may mutually share the state values of the link capacitor 30 by exchanging it through a communication line.

The inverter 10 and converter 20 may perform predefined control logic and diagnostic logic using the shared state value. However, if there is difference in the measurement times of the shared state values, diagnostic accuracy may be reduced or a loss in power conversion gain may occur. Predefined compensation logic may be additionally applied to prevent this problem, but in this case, a complex data processing process places a burden on system operation.

The present invention relates to a technology for solving this problem and presents a power system structure that can minimize measurement timing errors between power conversion devices without applying complex compensation logic and a communication method for such power system.

Hereinafter, preferred embodiments according to the present invention will be described in detail with reference to the attached drawings.

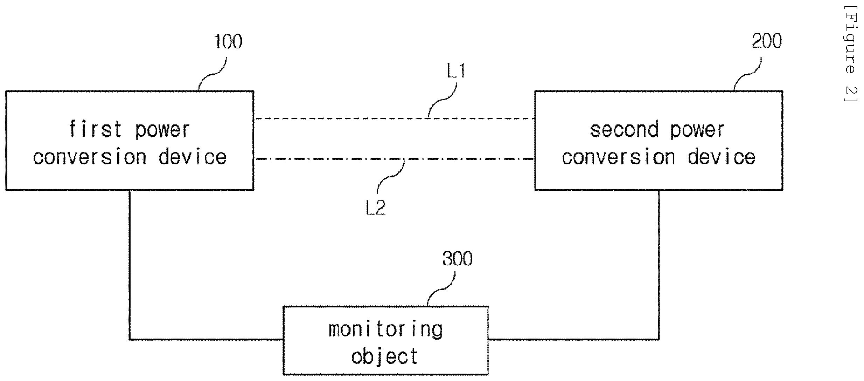

FIG. 2 is a block diagram of a power system according to embodiments of the present invention.

Referring to FIG. 2, a power system according to embodiments of the present invention may include a first power conversion device 100 and a second power conversion device 200.

The first power conversion device 100 and the second power conversion device 200 may correspond to a converter or inverter. For example, the first power conversion device 100 may be a DC/AC inverter and the second power conversion device 200 may be a DC/DC converter.

The first power conversion device 100 and the second power conversion device 200 may include control devices and communication modules. Here, the communication module may transmit and receive data through a communication line, and the control device may be configured to perform a predefined control process or diagnostic process using the transmitted and received data.

The first power conversion device 100 and the second power conversion device 200 may be connected to a monitoring object 300 through a status measurement line. Here, the monitoring object 300 may correspond to a link capacitor, but the monitoring object is not limited to a specific entity in the present invention.

The first power conversion device 100 and the second power conversion device 200 may each measure state values of the monitoring object 300 through a state measurement line. For example, the first power conversion device 100 and the second power conversion device 200 may collect state values including voltage values and current values of the link capacitor through the state measurement line.

The power system may include a first communication line L1 connecting the first power conversion device 100 and the second power conversion device 200.

In addition, the power system may include a second communication line L2 connecting the first power conversion device 100 and the second power conversion device 200. Here, the second communication line L2 may be configured as a separate line from the first communication line L1.

The first communication line L1 may be configured to perform communication for transmitting and receiving data. For example, the first power conversion device 100 and the second power conversion device 200 may transmit and receive one or more state values of the monitoring object 300 through the first communication line L1.

The second communication line L2 may be configured to perform communication to synchronize measurement times of the state values. Here, one or more of the first power conversion device 100 and the second power conversion device 200 may transmit a specific signal for synchronizing the measurement times of the state values through the second communication line L2.

The synchronization signal for matching the measurement times of the state values may include one or more of: a first signal requesting to start measuring the state values; and a second signal indicating an arrival of a preset measurement period.

When one of the first power conversion device 100 and the second power conversion device 200 transmits a synchronization signal to the other through the second communication line L2, the first power conversion device 100 and the second power conversion device 200 may measure the state values of the monitoring object 300 immediately after transmitting and receiving the synchronization signal and exchange the state values through the first communication line L1 to share the state values with each other.

According to embodiments of the present invention, after synchronizing the measurement times through a communication channel L2 configured separately from the data communication channel L1, the power conversion devices measure the state values and exchange data, thereby resulting in no measurement error between the power conversion devices.

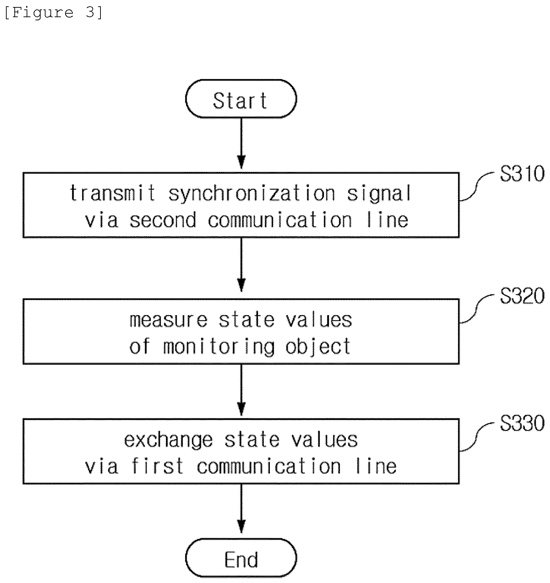

FIG. 3 is an operational flowchart of a communication method of the power system according to the embodiments of present invention.

Any one of the first power conversion device and the second power conversion device may transmit a synchronization signal for synchronizing the measurement times of the state values through the second communication line (S310). Here, the synchronization signal may include one or more of: a first signal requesting a start of measurement of the state values; and a second signal indicating an arrival of a preset measurement period.

Here, a transmitting entity of the synchronization signal may be predefined.

For example, the first power conversion device may be preset as the transmitting entity, or the second power conversion device may be preset as the transmitting entity.

For another example, if a measurement time point or measurement period is predefined in each of the first power conversion device and the second power conversion device, the device whose measurement time or measurement period has arrived may transmit a synchronization signal to the other device.

After the synchronization signal is transmitted by the transmitting entity, the first power conversion device and the second power conversion device may each measure state values of a monitoring object (S320).

Specifically, when a power conversion device (transmitting entity) that is supposed to transmit the synchronization signal transmits the synchronization signal to the other power conversion device (receiving entity), the transmitting entity measures state values immediately after transmitting the synchronization signal and the receiving entity may measure state values immediately after receiving the synchronization signal. In other words, the first power conversion device and the second power conversion device may each measure the state values of the monitoring object immediately after transmitting and receiving the synchronization signal.

Thereafter, the first power conversion device and the second power conversion device may exchange the state values measured in S320 with each other through the first communication line (S330).

The first power conversion device and the second power conversion device may perform a predefined control process or diagnostic process using the shared state values. Here, the shared state values are values measured at the same point in time, so a decrease in diagnostic accuracy or a loss of power conversion gain can be prevented.

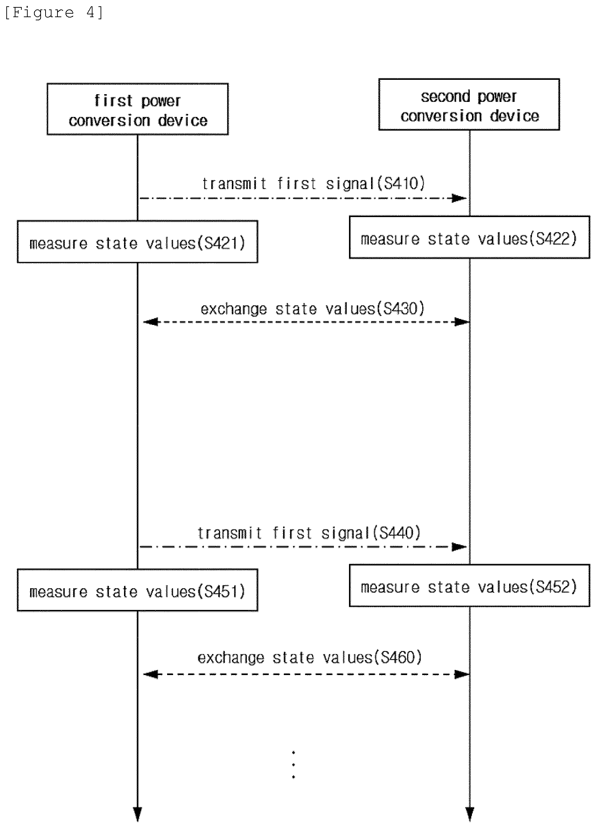

FIG. 4 is an operational flowchart of a communication method of a power system according to a first embodiment of the present invention.

The communication method of the power system shown in FIG. 4 is an embodiment in which a transmitting entity of the synchronization signal is determined to the first power conversion device and the synchronization signal is defined as the first signal that is a measurement start request signal.

The first power conversion device set as the transmitting entity may transmit the first signal, which is a signal requesting a start of the state value measurement, to the second power conversion device through the second communication line when its preset measurement time point or measurement period arrives (S410).

The first power conversion device may measure one or more state values of the monitoring object immediately after transmitting the first signal (S421) and the second power conversion device may measure one or more state values of the monitoring object immediately after receiving the first signal (S422).

The first power conversion device and the second power conversion device may exchange individually measured state values with each other through the first communication line (S430).

Thereafter, the first power conversion device may check whether its measurement time point or measurement period has arrived.

When the corresponding measurement time point or measurement period arrives, the first power conversion device may transmit the first signal to the second power conversion device through the second communication line (S440).

The first power conversion device may measure one or more state value of the monitoring object immediately after transmitting the first signal (S451) and the second power conversion device may measure one or more state values of the monitoring object immediately after receiving the first signal (S452).

The first power conversion device and the second power conversion device may exchange individually measured state values with each other through the first communication line (S460).

The first power conversion device and the second power conversion device may perform communication with each other by repeatedly performing S410 to S430 until the power system is transitioned to a stop mode.

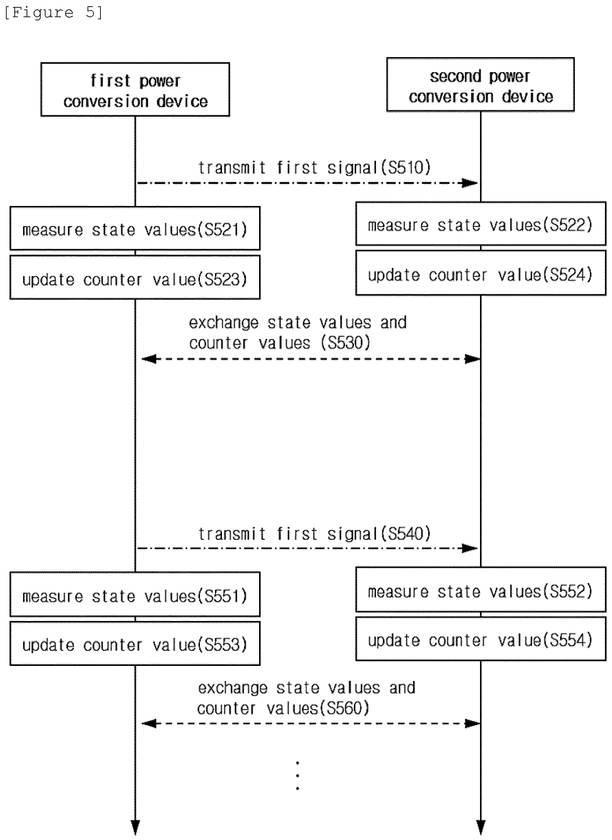

FIG. 5 is an operational flowchart of a communication method of a power system according to a second embodiment of the present invention.

The communication method of the power system shown in FIG. 5 is an embodiment in which a step of sharing counter values is added to the communication method of FIG. 4.

The first power conversion device determined as the transmitting entity may transmit the first signal, which is a signal requesting a start of the state value measurement, to the second power conversion device through the second communication line when its preset measurement time or measurement period arrives (S510).

The first power conversion device may measure one or more state values of the monitoring object immediately after transmitting the first signal (S521) and the second power conversion device may measure one or more state values of the monitoring object immediately after receiving the first signal (S522).

In addition, the first power conversion device may update a previously stored counter value immediately after transmitting the first signal (S523) and the second power conversion device may update a previously stored counter value immediately after receiving the first signal (S524). Here, the counter values may be stored in storage devices of each of the first power conversion device and the second power conversion device and may have the same value.

For example, when the first signal is transmitted and received, the first power conversion device updates a counter value (n) stored in its own storage device by increasing it by 1 (n+1) and the second power conversion device also updates a counter value (n) stored in its own storage device by increasing it by 1 (n+1).

The first power conversion device and the second power conversion device may exchange individually measured state values and counter values through the first communication line (S530).

Thereafter, the first power conversion device may check whether its measurement time or measurement period has arrived.

When the corresponding measurement time or measurement period arrives, the first power conversion device may transmit the first signal to the second power conversion device through the second communication line (S540).

The first power conversion device may measure one or more state values of the monitoring object immediately after transmitting the first signal (S551) and updates its own counter value (S553), whereas the second power conversion device may measure one or more state values of the monitoring object immediately after receiving the first signal (S552) and update its own counter value (S554).

The first power conversion device and the second power conversion device may exchange individually measured state values and counter values through the first communication line (S560).

The first power conversion device and the second power conversion device may perform communication each other by repeatedly performing S510 to S530 until the power system is switched to a stop mode.

According to this embodiment, the first power conversion device and the second power conversion device share the state values measured at the same time point and the counter values which are managed as the same value, and thus, a problem which measurement order of the shared state values is shifted or pushed back can be prevented.

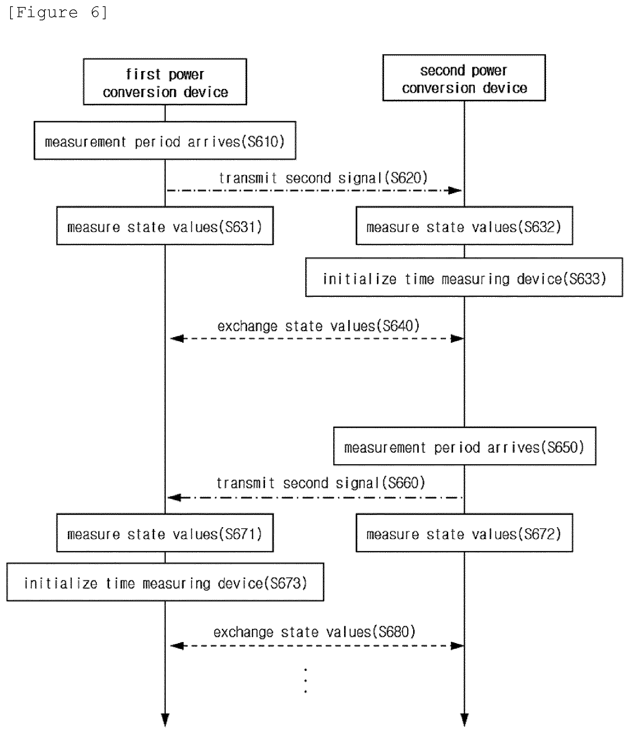

FIG. 6 is an operational flowchart of a communication method of a power system according to a third embodiment of the present invention.

The communication method of the power system shown in FIG. 6 is an embodiment in which the state value measurement periods of the first and second power conversion devices are preset to the same period, the transmitting entity of the synchronization signal is preset to a device whose measurement period arrives first, and the synchronization signal is defined as a second signal that is a notification signal of an arrival of the measurement period.

The first power conversion device and the second power conversion device may each check whether the measurement period has arrived through their own time measuring device (e.g., a timer).

When the measurement period of the first power conversion device arrives first (S610), the first power conversion device may transmit a second signal, which is a notification signal of the arrival of the measurement period, to the second power conversion device through a second communication line (S620).

The first power conversion device may measure one or more state values of the monitoring object immediately after transmitting the second signal (S631) and the second power conversion device measure one or more state values of the monitoring object immediately after receiving the second signal (S632).

Here, the second power conversion device that has received the second signal may initialize its own time measuring device (S633) so that its own time measuring device is synchronized with the time measuring device of the first power conversion device. Thereafter, the first power conversion device and the second power conversion device may each check whether the next measurement period has arrived through their own time measuring devices.

The first power conversion device and the second power conversion device may exchange individually measured state values with each other through the first communication line (S640).

Thereafter, when the measurement period of the second power conversion device arrives first (S650), the second power conversion device may transmit a second signal, which is a notification signal of an arrival of the measurement period, to the first power conversion device through the second communication line (S660).

The second power conversion device may measure one or more state values of the monitoring object immediately after transmitting the second signal (S672) and the first power conversion device may measure one or more state values of the monitoring object immediately after receiving the second signal (S671).

Here, the first power conversion device that has received the second signal may initialize its own time measuring device (S673) so that its own time measuring device is synchronized with the time measuring device of the second power conversion device. Thereafter, the first power conversion device and the second power conversion device may each check whether the next measurement period has arrived through their own time measuring devices.

The first power conversion device and the second power conversion device may exchange individually measured state values with each other through the first communication line (S680).

The first power conversion device and the second power conversion device may perform communication each other by repeatedly performing S610 to S640 until the power system is switched to a stop mode.

According to this embodiment, it is possible to prevent minute errors in measurement timing that may be caused by the time measuring device even when the power conversion devices are set to the same measurement period.

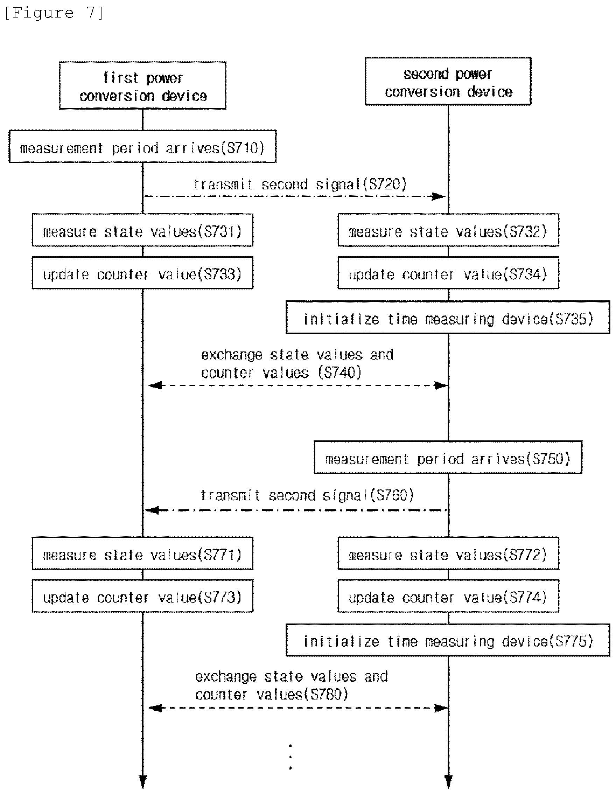

FIG. 7 is an operational flowchart of a communication method of a power system according to a fourth embodiment of the present invention.

The communication method of the power system shown in FIG. 7 is an embodiment in which a step of sharing counter values is added to the communication method of FIG. 6.

The first power conversion device and the second power conversion device may each check whether the measurement period has arrived through their own time measuring devices (e.g., a timer).

When the measurement period of the first power conversion device arrives first (S710), the first power conversion device may transmit a second signal, which is a notification signal of the arrival of the measurement period, to the second power conversion device through a second communication line (S720).

The first power conversion device may measure one or more state values of the monitoring object immediately after transmitting the second signal (S731) and the second power conversion device measure one or more state values of the monitoring object immediately after receiving the second signal (S732).

In addition, the first power conversion device may update its previously stored counter value immediately after transmitting the second signal (S733) and the second power conversion device may update its previously stored counter value immediately after receiving the second signal (S734).

Here, the second power conversion device that has received the second signal may initialize its own time measuring device (S735) so that its own time measuring device is synchronized with the time measuring device of the first power conversion device. Thereafter, the first power conversion device and the second power conversion device may each check whether the next measurement period has arrived through their own time measuring devices.

The first power conversion device and the second power conversion device may exchange individually measured state values with each other through the first communication line (S740).

Thereafter, when the measurement period of the second power conversion device arrives first (S650), the second power conversion device may transmit a second signal, which is a notification signal of an arrival of the measurement period, to the first power conversion device through the second communication line (S760).

The second power conversion device may measure one or more state values of the monitoring object immediately after transmitting the second signal (S772) and update its own counter (S774). In addition, the first power conversion device may measure one or more state values of the monitoring object immediately after receiving the second signal (S771) and update its own counter (S773).

Here, the first power conversion device that has received the second signal may initialize its time measuring device (S775).

The first power conversion device and the second power conversion device may exchange individually measured state values and counter values through the first communication line (S780).

The first power conversion device and the second power conversion device may perform communication each other by repeatedly performing S710 to S740 until the power system switches to a stop mode.

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A power system comprising:
a first power conversion device;
a second power conversion device;
a first communication line connecting the first power conversion device and the second power conversion device; and
a second communication line connecting the first power conversion device and the second power conversion device,
wherein each of the first power conversion device and the second power conversion device measures one or more state values for a monitoring object and exchanges the measured state values through the first communication line, and
wherein one or more of the first power conversion device and the second power conversion device performs communication to synchronize measurement time points of the state values through the second communication line.

2. The power system of claim 1, wherein the second communication line is a separate line from the first communication line.

3. The power system of claim 1, wherein any one of the first power conversion device and the second power conversion device is configured to transmit a first signal requesting initiation of state value measurement to the other via the second communication line.

4. The power system of claim 3, wherein the one of the first power conversion device and the second power conversion device is predefined as a transmitting entity of the first signal.

5. The power system of claim 3, wherein the first power conversion device and the second power conversion device are configured to transmit the first signal to the other when a predetermined measurement time for itself arrives.

6. The power system of claim 3, wherein the one of the first power conversion device and the second power conversion device transmitting the first signal measures the one or more state values immediately after transmitting the first signal,
the other one of the first power conversion device and the second power conversion device receiving the first signal measures the state values immediately after receiving the first signal, and
the first power conversion device and the second power conversion device share measured state values with each other through the first communication line.

7. The power system of claim 1, wherein measurement periods of the state values of the first power conversion device and the second power conversion device are predetermined to the same period, and
wherein any one of the first power conversion device and the second power conversion device is configured to transmit a second signal indicating arrival of a measurement period of itself to the other via the second communication line.

8. The power system of claim 7, wherein, among the first power conversion device and the second power conversion device, the one whose measurement period arrives earlier is configured to transmit the second signal to the other.

9. The power system of claim 8, wherein the one of the first power conversion device and the second power conversion device transmitting the second signal measures the state values immediately after transmitting the second signal,
the other one of the first power conversion device and the second power conversion device receiving the second signal measures the state values, immediately after receiving the second signal, and
the first power conversion device and the second power conversion device share measured state values with each other through the first communication line.

10. The power system of claim 8, wherein the one of the first power conversion device and the second power conversion device transmitting the second signal determines whether the next measurement period has arrived through its own time measuring device immediately after transmitting the second signal, and
wherein the other one of the first power conversion device and the second power conversion device receiving the second signal initializes its own time measuring device immediately after receiving the second signal and determines whether the next measurement period has arrived through its initialized time measuring device.

11. The power system of claim 1, wherein, upon a specific signal for synchronizing the measurement time points being transmitted and received through the second communication line,
each of the first power conversion device and the second power conversion device measures the state values, updates a previously stored counter value, and exchanges the state values and the counter values through the first communication line.

12. A communication method in a power system including a first power conversion device and a second power conversion device interconnected through a first communication line and a second communication line, the method comprising:
transmitting, by any one of the first power conversion device and the second power conversion device, a specific signal for synchronizing measurement time points of state values to the other through the second communication line;
measuring, by each of the first power conversion device and the second power conversion device, one or more state values for a monitoring object; and
exchanging, by the first power conversion device and the second power conversion device, the measured state values through the first communication line.

13. The communication method of claim 12, wherein the transmitting the specific signal for synchronizing measurement time points of state value includes:
transmitting a first signal requesting initiation of measurement of a state value via the second communication line.

14. The communication method of claim 13, wherein the transmitting the specific signal for synchronizing measurement time points of state value includes:
transmitting, by any one which is predefined as a transmitting entity of the first signal among the first power conversion device and the second power conversion device, the first signal to the other.

15. The communication method of claim 13, wherein the transmitting the specific signal for synchronizing measurement time points of state value includes:
transmitting, by any one of the first power conversion device and the second power conversion device whose predetermined measurement time point for itself has arrived, the first signal to the other.

16. The communication method of claim 13, wherein the measuring one or more state values for the monitoring object includes:
measuring, by any one of the first power conversion device and the second power conversion device transmitting the first signal, the state values immediately after transmitting the first signal; and
measuring, by the other one of the first power conversion device and the second power conversion device receiving the first signal, the state values immediately after receiving the first signal.

17. The communication method of claim 12, wherein measurement periods of the state value of the first power conversion device and the second power conversion device are predetermined to the same period, and
wherein the transmitting the specific signal for synchronizing measurement time points of state values includes:
transmitting a second signal indicating the arrival of the measurement period via the second communication line.

18. The communication method of claim 17, wherein the transmitting the specific signal for synchronizing measurement time points of state value includes:
transmitting, by any one whose measurement time period arrives earlier among the first power conversion device and the second power conversion device, the second signal to the other one.

19. The communication method of claim 18, the measuring one or more state values for the monitoring object includes:
measuring, by the one of the first power conversion device and the second power conversion device transmitting the second signal, the state values immediately after transmitting the second signal; and
measuring, by the other one of the first power conversion device and the second power conversion device receiving the second signal, the state values immediately after receiving the second signal.

20. The communication method of claim 18, wherein the measuring one or more state values for the monitoring object includes:
determining, by the one of the first power conversion device and the second power conversion device transmitting the second signal, whether the next measurement period has arrived through its own time measuring device immediately after transmitting the second signal; and
initializing, by the other one of the first power conversion device and the second power conversion device receiving the second signal, its own time measuring device immediately after receiving the second signal and determining whether the next measurement period has arrived through its initialized time measuring device.

21. The communication method of claim 12, wherein the measuring one or more state values for the monitoring object further includes updating previously stored counter value of each of the first power conversion device and the second power conversion device, and
wherein the exchanging the state values includes exchanging the state values and the counter values via the first communication line.
